# EUROPEAN PATENT SPECIFICATION

(11) **EP 2 859 059 B1**
(45) Date of publication and mention of the grant of the patent: **18.12.2019**
(21) Application number: 13803888.0
(22) Date of filing: 10.06.2013
(51) Int. Cl.: C09K 3/14, C09G 1/02, H01L 21/321

(54) **COMPOSITION AND METHOD FOR POLISHING MOLYBDENUM**
ZUSAMMENSETZUNG UND VERFAHREN ZUM POLIEREN VON MOLYBDÄN
COMPOSITION ET PROCÉDÉ DE POLISSAGE DU MOLYBDÈNE

(30) Priority: 11.06.2012 US 201261658076 P
(43) Date of publication of application: 15.04.2015
(73) Proprietor: Cabot Microelectronics Corporation, Aurora, Illinois 60504 (US)
(72) Inventor: SINGH, Pankaj, Aurora, Illinois 60504 (US); JONES, Lamon, Aurora, Illinois 60504 (US)
(74) Representative: Barker Brettell LLP
(86) International application number: PCT/US2013/044981
(87) International publication number: WO 2013/188296

(56) References cited:
- WO-A1-2008/030420
- WO-A1-2008/057593
- WO-A1-2008/057593
- US-A1- 2004 229 461
- US-A1- 2006 099 814
- US-A1- 2010 075 502
- US-A1- 2010 210 184
- US-B2- 7 524 347

## Description

### FIELD OF THE INVENTION

The invention relates to the semiconductor manufacturing arts. More particularly, this invention relates to compositions and methods for polishing a molybdenum surface.

### BACKGROUND OF THE INVENTION

'Molybdenum metal is utilized in a number of industrial applications, including microelectronic devices (e.g., for interconnects, photo masks, and other uses). In such applications, molybdenum initially is utilized in an excess amount, and then at least some molybdenum must be removed by polishing or lapping, in a controlled manner, to achieve surface properties suitable e.g., for semiconductor device manufacture.

WO2008/030420 discloses a method for chemically-mechanically polishing a substrate comprising at least one layer of silicon carbide with a polishing composition comprising a liquid carrier, an abrasive, and an oxidizing agent.

Abrasive materials are commonly utilized in polishing and lapping of metals. In such applications, abrasive particles are suspended in a liquid medium, such as water, sometimes with the aid of a surfactant as a dispersing agent. Polishing of metallic molybdenum surfaces often is accomplished using abrasives of varying sizes to obtain a desired surface roughness. Currently used abrasives generally require multiple steps to polish molybdenum surfaces, which can mean using multiple machines and/or parts and abrasive changes, which can adversely affect the processing time for each part.

Abrasive materials typically are suspended in a liquid carrier, such as water or an aqueous medium containing water. When the abrasive is suspended in the liquid carrier, it preferably is colloidally stable. The term "colloid" refers to the suspension of abrasive particles in the liquid carrier. "Colloidal stability" refers to the maintenance of that suspension over time. In the context of this invention, an abrasive suspension is considered colloidally stable if, when the silica is placed into a 100 mL graduated cylinder and allowed to stand without agitation for a time of 2 hours, the difference between the concentration of particles in the bottom 50 mL of the graduated cylinder ([B] in terms of g/mL) and the concentration of particles in the top 50 mL of the graduated cylinder ([T] in terms of g/mL,) divided by the total concentration of particles in the abrasive composition ([C] in terms of g/mL) is less than or equal to 0.5 (i.e., ([B]-[T])/[C]≤0.5). The value of (([B]-[T])/[C] desirably is less than or equal to 0.3, and preferably is less than or equal to 0.1.

There is an ongoing need for new compositions and methods for polishing molybdenum surfaces. The present invention addresses this need.

### BRIEF SUMMARY OF THE INVENTION

The present invention provides an aqueous chemical-mechanical polishing (CMP) composition for polishing a molybdenum-containing substrate, the composition comprising an aqueous carrier having a pH in the range of 3 to 6 and containing, at point of use:
(a) a particulate abrasive;
(b) a water soluble surface active material, wherein the particulate abrasive comprises alpha-alumina and the surface active agent is a cationic material; wherein the cationic material is a cationic polymer; and
(c) an oxidizing agent..

The choice of the surface active material is based on the zeta potential of the particulate abrasive, such that when the abrasive has a positive zeta potential, the surface active material comprises a cationic material.
In another aspect, the present invention provides an aqueous chemical-mechanical polishing (CMP) composition for polishing molybdenum, the composition comprising an aqueous carrier having a pH in the range of 3 to 6 and containing, at point of use: (a) 0.5 to 6 wt% of a particulate abrasive; (b) 25 to 5,000 ppm of a water soluble surface active material, wherein the particulate abrasive comprises alpha-alumina and the surface active agent is a cationic material; wherein the catioinic material is a cationic polymer and (c) 0.1 to 1.5 wt% of an oxidizing agent.

An example of a cationic polymer useful in the compositions and methods described herein is a poly(methacryloxyethyl trimethylammonium) halide (e.g., a chloride).

The aqueous CMP comprises an aqueous carrier having a pH in the range of 3 to 6, and may contain, at point-of-use, 0.5 to 6 percent by weight (wt%) or a particulate abrasive, 25 to 5,000 parts-per-million (ppm) of the water soluble surface active material, and 0.1 to 1.5 wt% of the oxidizing agent.

In another aspect, the present invention provides a CMP method for polishing a molybdenum-containing substrate. The method comprises the steps of contacting a surface of the substrate with a polishing pad and an aqueous CMP composition as described herein, and causing relative motion between the polishing pad and the substrate while maintaining a portion of the CMP composition in contact with the surface between the pad and the substrate for a time period sufficient to abrade at least a portion of the molybdenum from the substrate.

### BRIEF DESCRIPTION OF THE DRAWINGS

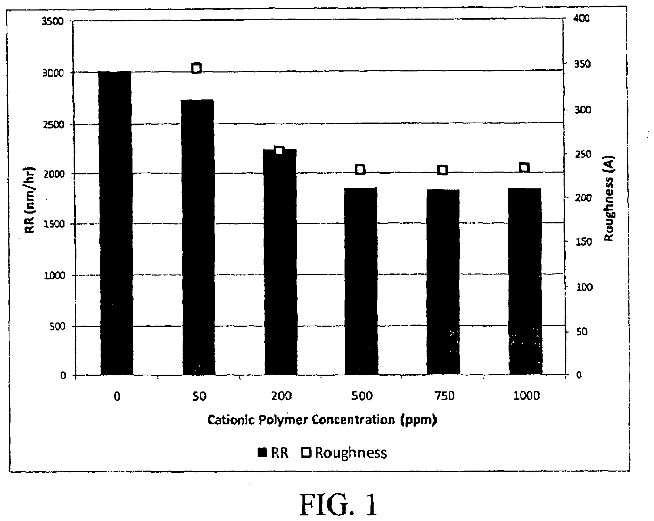

FIG.1 provides a graph of Mo removal rate (RR) for CMP compositions comprising various concentrations of cationic polymer (bars, left axis), as well as a plot of average roughness (boxes, right axis) obtained by polishing Mo wafers with each composition.

### DETAILED DESCRIPTION OF THE INVENTION

The present invention provides a chemical-mechanical polishing (CMP) composition for polishing a molybdenum-containing substrate, the composition comprising, an aqueous carrier having a pH in the range of 3 to 6 and containing, at point of use: (a) a particulate abrasive; (b) a water soluble surface active material, wherein the particulate abrasive comprises alpha-alumina and the surface active agent is a cationic material; wherein the catioinic material is a cationic polymer and (c) an oxidizing agent.
The present invention also provides an aqueous chemical-mechanical polishing (CMP) composition for polishing molybdenum, the composition comprising an aqueous carrier having a pH in the range of 3 to 6 and containing, at point of use: (a) 0.5 to 6 wt% of a particulate abrasive; (b) 25 to 5,000 ppm of a water soluble surface active material, wherein the particulate abrasive comprises alpha-alumina and the surface active agent is a cationic material, wherein the cationic material is a cationic polymer; and (c) 0.1 to 1.5 wt% of an oxidizing agent.
The surface active material is selected based on the zeta potential of the particulate abrasive, such that when the abrasive has a positive zeta potential, the surface active material comprises a cationic material.

The aqueous carrier can comprise, consist essentially of: or consist of any aqueous solvent, e.g., water, an aqueous alcohol (e.g., aqueous methanol, aqueous ethanol, aqueous ethylene glycol, and the like), and the like. Preferably, the aqueous carrier comprises deionized water.

The particulate abrasive materialof the CMP compositions of the invention is alpha-alumina), which has a positive zeta potential.

The abrasive material preferably has a mean particle size in the range of 50 nm to 150 nm, more preferably 90 nm to 120 nm. Preferably, the abrasive material is suspended in an aqueous medium at: a concentration in the range of 0.5 to 6 wt% at point-of-use. For alumina (e.g., alpha-alumina) the concentration of abrasive preferably is in the range of 0.5 to 3 wt%. As used herein, the phrase "point of fuse" refers to the concentration of a given component that will be used directly in a CMP process, without further dilution. The point of use concentration generally is achieved by dilution of a more concentrated composition (e.g., just before or within a few days prior to use).

The water-soluble surface active materialsl in the CMP compositions of the invention are selected based on the zeta potential of the particulate abrasive included in the composition. As described herein, cationic polymers and/or surfactants are used with abrasives having a positive zeta potential. Optionally, the cationic material can be combined with a nonionic polymer or surfactant, if desired.

Cationic polymers useful in the compositions and methods of the present invention include homopolymers of cationic monomers, e.g., a poly(diallyldimethylammonium) halide such as poly(diallyldimethylammonium) chloride (polyDADMAC), a poly(inethacryloyloxyethyltrimethylammonium) halide such as poly(methacryloyloxyethyltrimethylammonium) chloride (polyMADQUAT), and the like. In addition, the cationic polymer can be a copolymer of cationic and nonionic monomers (e.g., alkylacrylates, alkylmethacrylates, acrylamide, styrene, and the like), such as poly(acrylamide-co-diallyldimethylammonium) chloride. Some other non-limiting examples of such cationic polymer include polyethyleneimine, ethoxylated polyethyleneimine, poly(diallyldimeth3,4ammonium) halide, poly(amideamine), poly(methacryloyloxyethyldimethylammonium) chloride, poly(vinylpyrrolidone), poly(vinylimidazole), poly(vinylpyridine), and poly(vinylamine). A preferred cationic polymer for use in the CMP compositions of the invention is a poly(methacryloyloxyethyl trimethylammonium) halide (e.g., chloride), such as the polymer commercially available from Alco Chemical Inc. under the tradename ALCO 4773. Other suitable cationic materials include cationic surfactants, such as tetraalkylammonium compounds, e.g., hexadecyltrimethylammonium bromide, also known as cetyltrimethylammoniuni bromide; C.TAB), 1-decyltrimethylammonim chloride (DPC), and the like.

The cationic polymer can have any suitable molecular weight Typically, the polishing composition comprises a cationic polymer having a molecular weight of S kiloDalatons (kDa) or more (e.g., 10 kDa or more, 20 kDa or more, 30 kDa or more, 40 k.Da or more, 50 kDa or more, or 60 kDa or more) cationic polymer. The polishing composition preferably comprises a cationic polymer having a molecular weight of 100 kDa or less (e.g., 80 kDa or less, 70 kDa or less, 60 kDa or less, or 50 kDa or less). Preferably, the polishing composition comprises a cationic polymer having a molecular weight of 5 kDa to 100 kDa (e.g., 10 kDa to 80 kDa, 10 kDa to 70 kDa, or 15 kDa to 70 kDa.

Nonionic polymers may include, for example, polyacrylamide (PAM) homopolymers, and. copolymers of acrvlamide with one or more other nonionic monomer such as methacrylamide, N-vinylp⁻yrrolidone, and the like. Preferably, nonionic polymers have an average molecular weight of 100 kDa or less, for example, 10 kDa or less, or in the range of 1 to 10 kDa.

The water-soluble surface active material (e.g., polymer or surfactant) may be present in the composition at a concentration in the range of 25 to 5,000 parts-per-million (ppm), e.g., .100 to 1,000 ppm.

The abrasive desirably is suspended in the CMP composition, more specifically in the aqueous component of the CMP composition, and. is colloidally stable. The term colloid refers to the suspension of abrasive particles in the liquid carrier. Colloidal stability refers to the maintenance of that suspension over time.

The alumina abrasive is used in conjunction with a cationic material (e.g., a polymer or surfactant) in the CMP composition of the present invention. Alumina have positive zeta potentials, which complement the zeta potential of a cationic polymer, and allow both components to exist within the same composition without precipitation of components. Inclusion of a cationic polymer such as ALCO 4773 in the CMP composition reduces surface defects on the molybdenum being polished, relative to CMP compositions lacking the cationic material.

The polishing composition has an acidic pH, in the range of 3 to 6. The pH of the polishing composition can be achieved and/or maintained by any suitable means. For example, the pH can he maintained through the use of a suitable buffer, if desired. In addition, the other components of the composition (e.g., the abrasive and the surface active agent) also help to establish and maintain the pH. More specifically, the polishing composition can further comprise a pH adjustor, a pH buffering agent, or a combination thereof. The pH adjustor can comprise, consist essentially of, or consist of any suitable pH-adjusting compound. For example, the pH adjustor can be the acid of the polishing composition. The p11 buffering agent can be any suitable buffering agent, for example, phosphates, acetates, berates, sulfonates, carboxylates, ammonium salts, and the like. The polishing composition can comprise any suitable amount of a pH adjustor and/or a pH buffering agent:, provided such amount is sufficient to achieve and/or maintain the desired. pH of the polishing composition, e.g., within the ranges set forth herein.

The polishing composition also comprises an oxidizing agent, which can be any suitable oxidizing agent for one or more materials of the substrate to be polished with the polishing composition. Preferably, the oxidizing agent is selected from the group consisting of a bromate, a bromite, a chlorate, a chlorite, hydrogen peroxide, a hypochlorite, an iodate, a monoperoxysulfate, a monoperoxysuffite, a monoperoxyphosphate, a monoperoxyhypophosphate, a monoperoxymophosphate, an organ-halo-oxy compound, a periodate, a permanganate, peroxyacetic acid, a ferric salt (e.g., ferric nitrate), and a combination of two or more thereof. The oxidizing agent can be present in the polishing composition in any suitable amount. Typically, the polishing composition comprises 0.01 wt. % or more (e.g., 0.02 wt. % or more, 0.1 wt. % or more, 0.5 wt. % or more, or 1 wt. % or more) oxidizing agent. The polishing composition preferably comprises 2 wt. % or less (e.g., 0.1 to 1.5 wt. % at point of use) of the oxidizing agent when a "strong" oxidizer is used. Hydrogen peroxide is a particularly preferred strong oxidizing agent. For weaker oxidizing agents, such as ferric nitrate, a higher concentration (e.g., up to 10 wt. % or more) may be required or desired.

It will be appreciated that many of the aforementioned compounds (e.g., polymers, surfactants, acids, buffering, agents) can exist in the form of a salt' (e.g., a metal salt, an ammonium salt, or the like), an acid, or as a partial salt. Furthermore, certain compounds or reagents may perform more than one function. For example, some compounds can function both as a chelating agent and an oxidizing agent (e.g., certain ferric nitrates and the like).

The polishing slurries of the present invention also can be provided as a concentrate, which is intended to be diluted with an appropriate amount of aqueous solvent (e.g., water) prior to use. In such an embodiment, the polishing slurry concentrate can include the various components dispersed or dissolved in aqueous solvent in amounts such that, upon dilution of the concentrate with an appropriate amount of aqueous solvent, each component of the polishing composition will be present in the polishing composition in an amount within the appropriate range for use.

The polishing slurries of the invention can be prepared by any suitable technique, many of which are known to those skilled in the art. The polishing slurry can be prepared in a batch or continuous process. Generally, the polishing slurry can be prepared by combining the components thereof in any order. The term "component" as used herein includes individual ingredients (e.g., abrasive, polymer, surfactant, acids, bases, buffers, oxidizing agents, and the like), as well as any combination of ingredients. For example, the abrasive can be dispersed in water, the surface active material, and any other additive material can be added, and mixed by any method that is capable of incorporating the components into the polishing slurry. The pH can be further adjusted, if desired, at any suitable time by addition of an acid, base or a buffer, as needed. Preferably, the oxidizing agent in assed to the composition shortly before use (e.g., a few minutes to a few days before use).

The CMP methods of the present invention are particularly suited for use in conjunction with a chemical-mechanical polishing apparatus. Typically, the CMP apparatus comprises a platen, which, when in use, is in motion and has a velocity that results from orbital, linear, and/or circular motion, a polishing pad in contact with the platen and moving with the platen when in motion, and a carrier that holds a substrate to be polished in contact with the pad and moving relative to the surface of the polishing pad. A CMP composition is typically pumped onto the polishing pad to aid in the polishing process. The polishing of the substrate is accomplished by the combined abrasive action of the moving polishing pad and the CMP composition of the invention present on the polishing pad, which abrades at least a portion of the surface of the substrate, and thereby polishes the surface.

A substrate can be planarized or polished with a CMP composition of the invention using any suitable polishing pad (e.g., polishing surface). Suitable polishing pads include, for example, woven and non-woven polishing pads. Moreover, suitable polishing pads can comprise any suitable polymer of varying density, hardness, thickness, compressibility, ability to rebound 'upon compression, and compression modulus. Suitable polymers include, for example, polyvinylchloride, polyvinylfluoride, nylon, fluorocarbon, polycarbonate, polyester, polyacrylate, polyether, polyethylene, polyamide, polyurethane, polystyrene, polypropylene, coformed products thereof, and mixtures thereof.

Desirably, the CMP apparatus further comprises an *in situ* polishing endpoint detection system, many of which are known in the art. Techniques for inspecting and monitoring the polishing process by analyzing light or other radiation reflected from a surface of the workpiece are known in the art. Such methods are described, for example, in U.S. Patent 5,196,353 to Sandhu et al*,* U.S. Patent 5,433,651 to Lustig et al.*,* U.S. Patent 5,949,927 to Tang, and U.S. Patent 5,964,643 to Birang et al. Desirably, the inspection Of ⁻monitoring of the progress of the polishing, process with respect: to a. workpiece being polished enables the determination of the polishing end-point, i.e., the determination of when, to terminate the polishing process with respect to a particular workpiece.

The following non-limiting examples are provided to illustrate preferred embodiments of the methods of the present invention.

### EXAMPLE 1

Sintered, molybdenum wafers (2-inch square) were polished for 20 minutes with CMP slurries on a HYPREZ Model 15 polisher with an EPIC D100 polishing pad (concentric grooving; 1 minute ex situ conditioning between wafers with a TBW conditioner) at a down force (DF) of 9.4 pounds-per-square inch (psi), a platen speed of 75 revolutions-per-minute (rpm) and a slurry flow rate of 75 milliliters-per-minute (mL/min).

Polishing slurries containing 2, 6, and 12 wt% alpha-alumina in water at pH 4 provided Mo removal rates (RR) of 490, 650, and 830 nanometers-per-hour (nm/hr), Mo surfaces exhibited an average roughness (Ra) of 290 to 325 Angstroms (Å). Use of 5 wt% fumed silica in place of alumina lead to a Mo removal rate of 210 nm/hr at pH 4. Decreasing the pH to 2.3 increased the RR to 240 nm/hr with the silica slurry, whereas increasing the pH to 8 and 10 lead to removal rates of 180 to 190 nm/hr. Electrochemical evaluation indicated that: the silica slurries exhibited an oxidation ^{.}potential in the corrosion region at all pH values (see Table 1).

**Table 1.**

| Slurry pH | With Abrasion | | After abrasion | |
|---|---|---|---|---|
| | E_{corr} (mV) | i_{corr} (µA/cm²) | E_{corr} (mV) | i_{corr} (µA/cm²) |
| 2.3 | -536 | 5 | -425 | 2 |
| 8.0 | -693 | 14 | -689 | 11 |

Addition of an oxidizing agent (14 to 140 ppm ferric nitrate, 0.2 wt% hydrogen peroxide, 0.2 wt% potassium periodate, or 0.2 wt% potassium permanganate) to the slurries resulted in higher oxidation and corrosion and unsuitable surface roughness characteristics.

### EXAMPLE 2

The effectiveness of corrosion inhibitors in abrasive slurries containing oxidizing agents was evaluated. Slurries comprising 2 wt% alpha-alumina and 0.2 wt% hydrogen peroxide at pH 4 were evaluated with traditional inhibitors used in copper polishing (glycine, 1,2,4-triazole, benzotriazole, 5-aminotetrazole) still afforded higher than desirable surface roughness. Fumed silica slurries showed similar results with glycine, lysine, and cationic polymer (polyMADQUAT; ALCO 4773).

In contrast to the results with fumed silica, alpha-alumina slurries including polyMADQUAT (50 to 1000 ppm) provided suitable Mo removal rates (RR.; 1700 to 2700 rnm/hr) and suitable roughness (Ra; 225 to 350 Å (see FIG. 1). For comparison, an alpha-alumina composition having the same formulation, but without the polyMADQUAT (first bar in FIG. 1), exhibited heavy surface staining and corrosion, resulting in an unacceptably rough surface beyond the scale of the plot in FIG. 1.

These results demonstrate that addition of a water soluble surface active material to polishing compositions comprising an abrasive and an oxidizing agent can provide unexpected improvements in surface roughness when the surface active agent is selected to complement the zeta potential of the abrasive (e.g., cationic polymer plus positive zeta potential abrasive), compared to slurries without added surface active agent, or with surface active agent and incompatible zeta potential (e.g., silica with polyMADQUAT).

## Claims

1. An aqueous chemical-mechanical polishing (CMP) composition for polishing a molybdenum-containing substrate, the composition comprising an aqueous carrier having a pH in the range of 3 to 6 and containing, at point of use:
(a) a particulate abrasive;
(b) a water soluble surface active material, wherein the particulate abrasive comprises alpha-alumina and the surface active agent is a cationic material; wherein the cationic material is a cationic polymer; and
(c) an oxidizing agent;

2. The CMP composition of claim 1 wherein the cationic polymer comprises a poly(methacryloxyethyltrimethylammonium) halide.

3. The CMP composition of claim 1 comprising an aqueous carrier having a pH in the range of 3 to 6 and containing, at point of use:
(a) 0.5 to 6 wt% of a particulate abrasive;
(b) 25 to 5,000 ppm of a water soluble surface active material, wherein the particulate abrasive comprises alpha-alumina and the surface active agent is a cationic material; wherein the cationic material is a cationic polymer and
(c) 0.1 to 1.5 wt% of an oxidizing agent.

4. The CMP composition of claim 3 wherein the water soluble surface active material comprises a poly(methacryloyloxyethyl trimethylammonium) halide.

5. The CMP composition of any one of claims 1 and 4 wherein oxidizing agent comprises hydrogen peroxide.

6. A chemical-mechanical polishing (CMP) method for polishing a molybdenum-containing substrate, the method comprising the steps of:
(a) contacting a surface of the substrate with a polishing pad and an aqueous CMP composition of claims 1 or 3; and
(b) causing relative motion between the polishing pad and the substrate while maintaining a portion of the CMP composition in contact with the surface between the pad and the substrate for a time period sufficient to abrade at least a portion of the molybdenum from the substrate.

## Patentansprüche

1. Wässrige Zusammensetzung zum chemisch-mechanischen Polieren (CMP) zum Polieren eines molybdänhaltigen Substrats, wobei die Zusammensetzung einen wässrigen Träger mit einem pH-Wert im Bereich von 3 bis 6 umfasst und am Einsatzort
(a) ein teilchenförmiges Schleifmittel;
(b) ein wasserlösliches oberflächenaktives Material, wobei das teilchenförmige Schleifmittel alpha-Aluminiumoxid umfasst und es sich bei dem oberflächenaktiven Mittel um ein kationisches Material handelt; wobei es sich bei dem kationischen Material um ein kationisches Polymer handelt; und
(c) ein Oxidationsmittel
enthält.

2. CMP-Zusammensetzung nach Anspruch 1, wobei das kationische Polymer ein Poly(methacryloxyethyltrimethylammonium)halogenid umfasst.

3. CMP-Zusammensetzung nach Anspruch 1, die einen wässrigen Träger mit einem pH-Wert im Bereich von 3 bis 6 umfasst und am Einsatzort
(a) 0,5 bis 6 Gew.-% eines teilchenförmigen Schleifmittels;
(b) 25 bis 5000 ppm eines wasserlöslichen oberflächenaktiven Materials, wobei das teilchenförmige Schleifmittel alpha-Aluminiumoxid umfasst und es sich bei dem oberflächenaktiven Mittel um ein kationisches Material handelt; wobei es sich bei dem kationischen Material um ein kationisches Polymer handelt; und
(c) 0,1 bis 1,5 Gew.-% eines Oxidationsmittels enthält.

4. CMP-Zusammensetzung nach Anspruch 3, wobei das wasserlösliche oberflächenaktive Material ein Poly(methacryloyloxyethyltrimethylammonium)halogenid umfasst.

5. CMP-Zusammensetzung nach einem der Ansprüche 1 bis 4, wobei das Oxidationsmittel Wasserstoffperoxid umfasst.

6. Verfahren zum chemisch-mechanischen Polieren (CMP) zum Polieren eines molybdänhaltigen Substrats, wobei das Verfahren folgende Schritte umfasst:
(a) Inberührungbringen einer Oberfläche des Substrats mit einem Polierkissen und einer wässrigen CMP-Zusammensetzung nach Anspruch 1 oder 3 und
(b) Bewirken von relativer Bewegung zwischen dem Polierkissen und dem Substrat, wobei ein Teil der CMP-Zusammensetzung mit der Oberfläche zwischen dem Kissen und dem Substrat über einen zum Abschleifen mindestens eines Teils des Molybdän von dem Substrat ausreichenden Zeitraum in Kontakt gehalten wird.

## Revendications

1. Composition aqueuse de polissage mécano-chimique (PMC) pour le polissage d'un substrat contenant du molybdène, la composition comprenant un support aqueux possédant un pH dans la plage de 3 à 6 et contenant, au moment de l'utilisation :
(a) un abrasif particulaire ;
(b) un matériau tensioactif hydrosoluble, l'abrasif particulaire comprenant de l'alpha-alumine et l'agent tensioactif étant un matériau cationique ; le matériau cationique étant un polymère cationique ; et
(c) un agent oxydant.

2. Composition de PMC selon la revendication 1, le polymère cationique comprenant un halogénure de poly(méthacryloxyéthyltriméthylammonium) .

3. Composition de PMC selon la revendication 1 comprenant un support aqueux possédant un pH dans la plage de 3 à 6 et contenant, au moment de l'utilisation :
(a) 0,5 à 6 % en poids d'un abrasif particulaire ;
(b) 25 à 5000 ppm d'un matériau tensioactif hydrosoluble, l'abrasif particulaire comprenant de l'alpha-alumine et l'agent tensioactif étant un matériau cationique ; le matériau cationique étant un polymère cationique ; et
(c) 0,1 à 1,5 % en poids d'un agent oxydant.

4. Composition de PMC selon la revendication 3, le matériau tensioactif hydrosoluble comprenant un halogénure de poly(méthacryloxyéthyltriméthylammonium) .

5. Composition de PMC selon l'une quelconque des revendications 1 à 4, l'agent oxydant comprenant du peroxyde d'hydrogène.

6. Procédé de polissage mécano-chimique (PMC) pour le polissage d'un substrat contenant du molybdène, le procédé comprenant les étapes de :
a) mise en contact d'une surface du substrat avec un tampon de polissage et un composition aqueuse de PMC selon la revendication 1 ou 3 ; et
b) provocation d'un mouvement relatif entre le tampon de polissage et le substrat tout en maintenant une partie de la composition de PMC en contact avec la surface entre le tampon et le substrat pendant une période de temps suffisante pour abraser au moins une partie du molybdène de la surface.
